Europäisches Patentamt

European Patent Office

Office européen des brevets

(11) Publication number: **0 504 759 A1**

# EUROPEAN PATENT APPLICATION

(21) Application number: **92104418.6**

(22) Date of filing: **13.03.92**

(51) Int. Cl.5: **G03F 7/095**, G03F 7/20

(30) Priority: **20.03.91 US 672394**

(43) Date of publication of application:
**23.09.92 Bulletin 92/39**

(84) Designated Contracting States:
**DE FR GB**

(71) Applicant: **EASTMAN KODAK COMPANY**
**343 State Street**
**Rochester, New York 14650-2201(US)**

(72) Inventor: **Lelental, Mark, c/o EASTMAN**
**KODAK COMPANY**
**Patent Department 343 State Street**
**Rochester New York 14650-2201(US)**
Inventor: **Palmeri, Rudolph F., c/o EASTMAN**
**KODAK COMPANY**
**Patent Department 343 State Street**
**Rochester New York 14650-2201(US)**
Inventor: **Pace, Laurel Jean, c/o EASTMAN**
**KODAK COMPANY**
**Patent Department 343 State Street**
**Rochester New York 14650-2201(US)**
Inventor: **Weiss, Armin Karl, c/o EASTMAN**
**KODAK COMPANY**
**Patent Department 343 State Street**
**Rochester New York 14650-2201(US)**

(74) Representative: **Brandes, Jürgen, Dr.-rer.-nat.**
**et al**
**Wuesthoff & Wuesthoff, Patent- und**
**Rechtsanwälte, Schweigerstrasse 2**
**W-8000 München 90(DE)**

(54) **Photoresist pattern-forming process suitable for integrated circuit production.**

(57) A pattern, useful in the production of integrated circuits, for positioning bond pads on a substrate (6) is formed. This process of forming this pattern includes patterning and opacifying a thin photoresist layer (2) which acts as a conformal optical mask for a thick photoresist layer (4) present below it. Exposure and development is then used to transfer the pattern to the thick photoresist layer (4). The patterned depressions formed in the thick photoresist layer (4) can then be filled with conductive material to serve as bond pads for bonding to an integrated circuit packaging system.

FIG.1

This invention relates to a process of forming a patterned photoresist layer, useful in the production of integrated circuits, for positioning bond pads on a substrate.

Integrated circuit ("IC") packages connect silicon chips to the devices they are designed to operate on. In forming such connections, chips often must be provided with a high number of input/output leads. However, the bonding techniques used to connect the IC chip to the package may limit the number of leads that may be incorporated on an individual chip.

Leads must be bonded precisely on a chip to form a complete connection with the conducting portions of the chip. Traditional methods of connecting the chip to the package include wire bonding, flip-chip solder bonding and tape automated bonding ("TAB").

Wire bonding and flip-chip solder bonding are serial processes whereby each lead on a chip is bonded separately. Therefore, as the number of leads increases, total bonding time increases dramatically.

TAB is a process by which all leads on a given chip are bonded at once. In a typical TAB process, copper "fingers" are prefabricated in the form of a continuous tape of repetitive sites and are simultaneously bonded by thermocompression to every lead on a silicon chip. TAB provides rapid, high lead density packaging. The advent of very large scale integration ("VLSI"), that is, chips containing a large number of leads (100 or more), has led to increased utilization of TAB processes.

Conventionally chips are prepared for TAB by placing conductive bond pads, or "bumps", over the existing contact pads on the chip. These bumps facilitate the bonding of the TAB leads to the IC contact pads. The process of placing bond pads on the surface of the chip is commonly known as "wafer bumping".

Various methods have been used to place the bumps on the chip. Often these methods have taken the form of a masking technique. For example, U.S. Patent No. 3,165,430 discloses a method for placing conductive material on a substrate for integrated circuit manufacture. In this patent, a substrate is coated with silicon oxide, over which a metal layer, such as aluminum, is placed. The metal layer is scribed to expose the underlying oxide layer. The metal layer then acts as a mask as the exposed oxide is chemically etched to expose an appropriate amount of substrate for the deposition of conductive material.

If greater precision in bump placement is desired, often a photolithographic process is used. In U.S. Patent No. 4,004,044, a masking method using a combination photoresist process with chemical etching is disclosed. A resin layer is placed on a silicon substrate and is overcoated with a photoresist layer. The photoresist layer is exposed and developed to form a pattern. The remaining photoresist acts as a mask for the resin layer which is chemically etched. Conductive material is then deposited on the exposed substrate.

Uniform height and adherence to strict geometric parameters are critical in VLSI technology. The bump size must be controlled to attain the high lead count desired and still maintain cost efficiency and small chip size. The ratio of the thickness of the photoresist to the desired bump height is critical to the resulting size and shape of the bump.

Prior art wafer bumping methods have involved making impressions in a photoresist which are shallower than the ultimate bump height. These impressions are filled to overflow and the bump grows sideways, resulting in a "mushroom-shaped" bump, which is unacceptable in VLSI applications. A process of this variety is disclosed in U.S. Pat. No. 3,700,497. In VLSI applications, it is desirable to form straight-wall bumps completely recessed within the photoresist. This achieves uniform bump geometry and maximizes the number of precisely placed bumps on the chip. As a result, cost is reduced and input/output lead count is decreased.

To be useful as a bonding member, a bump must exceed a threshold height. This is 5 to 50 mm, preferably 30 mm. As a result, the photoresist layer used to form patterns must be at least that thick.

The use of thick photoresists, however, has many disadvantages. The exposure required to pattern a thick photoresist layer of 30 mm is much greater in time and/or intensity than that required to pattern a thin layer of photoresist. Additionally, the pattern fidelity, with respect to edge definition and critical feature size, in a thick layer of photoresist is inferior to the pattern fidelity of a similarly patterned thin photoresist.

Prior art methods of dealing with these problems include using bi-layer photoresists such as disclosed in U.S. Patent No. 4,557,797. This patent discloses a multi-layer resist process that uses a thin anti-reflective coating introduced between the thick bottom layer of photoresist and the thin top photoresist layer. The thick photoresist planarizes the surface topography of the substrate, while the anti-reflective coating reduces light reflection from the substrate. This process is meant to improve the imaging of the top resist layer. The two layers must be selected to be sensitive to different wavelengths of optical radiation. As a result, two exposures with different wavelengths are needed, and this leads to increased complexity and production cost. Additionally, the types and combinations of photoresists available restrict the versatility of such a technique.

The present invention relates to a process of forming a patterned photoresist layer, which is useful in the production of integrated circuits and, in particular, for positioning bond pads on a suitable substrate, such as a silicon wafer. The invention features a bi-layer photoresist in which deep depressions can be precisely placed for excellent pattern definition.

The starting material for the process of the present invention is a substrate, such as a silicon wafer on which metal patterns have been formed, coated with a thick layer of photoresist over which a thin layer of photoresist is applied. In this process, the thin layer of photoresist is exposed to activating radiation of a predetermined pattern and developed to produce the predetermined pattern or its negative in the thin layer. The patterned thin layer of photoresist is then opacified to absorb specific wavelengths of radiation and, when exposed to such radiation, acts as a conformal mask for the thick layer of photoresist.

The thick layer of photoresist is then exposed to radiation which will increase the solubility of the thick layer of photoresist to a developer in only those locations which are not masked by the opacified thin layer of photoresist. The thick layer is developed to produce the predetermined pattern, in the form of impressions, in the thick layer. These impressions are equal to the depth of the thick layer of photoresist (5 to 50 mm) and exhibit uniform geometric dimensions and excellent pattern fidelity.

The impressions are filled with a bump of conductive material. The remaining photoresist is then removed from the substrate to leave bumps suitable for bonding by thermocompression or other means to the packaging material such as a patterned, continuous tape.

This invention represents a substantial improvement over prior methods of wafer bumping. The use of a bi-layer photoresist with thin and thick layers reduces initial exposure time and/or intensity to the thin layer and greatly increases the pattern fidelity in the thick layer. The use of a patterned, opacified thin photoresist layer as a conformal mask during the exposure of the thick photoresist layer provides the advantages of contact exposure without the attendant disadvantages. Mask degradation, dirt tracking, or diffusion, problems commonly encountered with conventional contact exposure techniques, do not occur in the process of the present invention.

Additionally, this precise method allows an increased packing density of bumps (number of bumps per unit area) and minimizes the amount of conductive material required per bump relative to procedures that result in "mushroom" bumps.

Finally, the process of the present invention permits both exposures to be carried out utilizing radiation sources of comparable spectral output.

FIG. 1 is a cross-sectional view of a substrate with metal patterns, coated with layers of photoresist being exposed to radiation through a mask.

FIG. 2 is a cross-sectional view of the article of FIG. 1 after development.

FIG. 3 is a cross-sectional view of the developed article of FIG. 2 after opacification.

FIG. 4 is a cross-sectional view of the article of FIG. 3 after a second exposure and development.

FIG. 5 is a cross-sectional view of the article of FIG. 4 after deposition of conductive material upon the substrate.

FIG. 6 is a cross-sectional view of the article of FIG. 5 after the remaining photoresist has been removed.

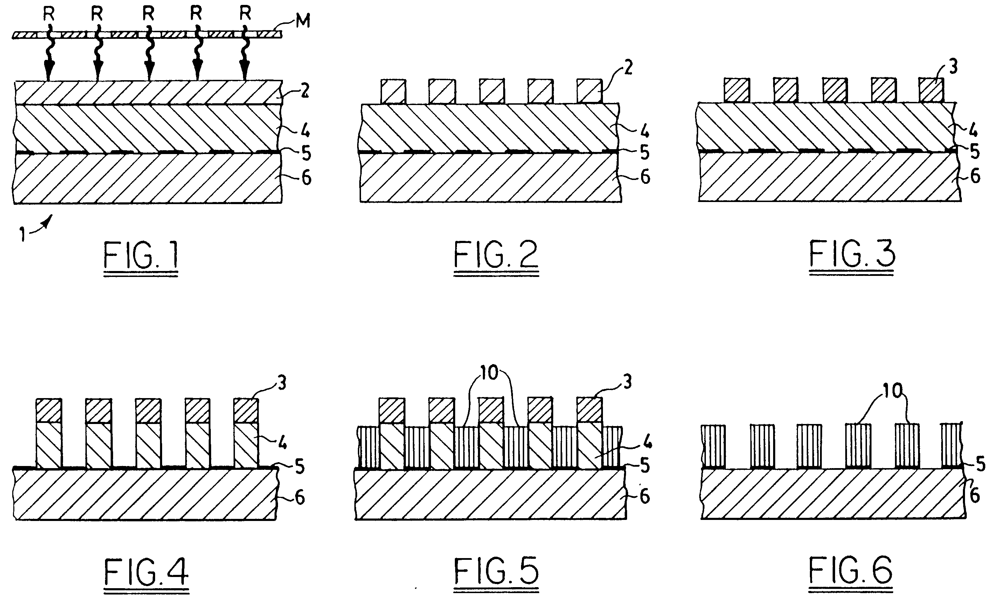

FIG. 1 is a cross-sectional view of an integrated circuit substrate coated with layers of photoresist being exposed to radiation through a mask. Laminate 1, consisting of substrate 6, thick photoresist layer 4, and thin photoresist layer 2 is formed by sequentially coating substrate 6 with these layers of photoresist.

Suitable substrates for the present process include silicon and compound III-V semiconductors known in the art such as gallium arsenide. A preferred substrate is a silicon wafer.

Substrate 6 is first coated with a patterned layer of conductive contact pads 5. The patterning of substrate 6 with contact pads 5 may be carried out by vacuum deposition with a mask or by separate photolithographic processes well known in the art. A suitable process, for example, is disclosed in U.S. Patent No. 4,004,044.

Contact pads 5 may comprise a bilayer composite of titanium-tungsten alloy overcoated with gold. Also suitable is chromium overcoated with gold. In these cases, the titanium-tungsten alloy and the chromium are used to improve the adhesion of the contact pads 5 to substrate 6.

The pattern of contact pads 5 must adhere generally to the predetermined pattern. That is, the locations of contact pads 5 must coincide with the locations where conductive material will be deposited to form bumps 10 as shown in FIG. 5. Contact pads 5 may be slightly larger than the impressions in thick photoresist layer 4 as shown in FIG. 4, but may not touch as that would render the resulting product of the process useless as an integrated circuit component.

Thick photoresist layer 4 may be coated on substrate 6 by any suitable photoresist coating method such as spin coating. Thick photoresist layer 4 preferably is a "positive working" photoresist (that is, a material whose solubility increases when exposed to activating radiation). A negative working photoresist (that is, one that becomes less soluble when exposed to activating radiation) is undesirable as thick photoresist layer 4 due to the difficulty of removing negative working, exposed thick photoresist 4 from substrate 6 after bump formation.

Positive working photoresists suitable as thick photoresist layer 4 include sensitized phenol-formaldehyde resins (also known as "novolak" resins), sensitized cresol-formaldehyde resins, and sensitized polysulfonamide resins. Preferred positive working photoresists for thick photoresist layer 4 are novolak-based resists having a viscosity ranging from 100-10,000 centipoise at 20 degrees Celsius, such as AZ-4620, supplied by American Hoechst Corp.

The thickness of thick photoresist layer 4 is largely dependent on the coatability and developability of the resist, the size requirements of bumps 10 to be ultimately formed on substrate 6 and the desired packing density of bumps, (number of bumps/unit area). Suitable thicknesses of layer 4 are in the range of 5-50 mm, preferably 30 mm.

Thin photoresist layer 2 is spin coated over thick layer 4. Thin layer 2 may be a positive or negative working photoresist. Suitable positive working photoresists include sensitized phenol-formaldehyde resins, sensitized cresol-formaldehyde resins, and sensitized polysulfonamide resins. Preferred positive working photoresists for thin layer 2 are novolak-based resists having a viscosity ranging from 1 to 50 centipoise at 20 degrees Celsius.

In a preferred embodiment of the present process, thin photoresist layer 2 is a negative working photoresist. FIGS. 1-6 are directed to this embodiment. The combination of thin negative working photoresist 2 and thick positive working photoresist 4, as shown in laminate 1 of FIG. 1, results in photoresists with different propensities for accepting opacifying agents. This permits use of a large selection of opacifying agents which will be readily accepted by thin photoresist layer 2 and not accepted by thick photoresist layer 4.

Preferred negative working photoresists are those resists that show minimal intermixing with the underlying resist layer, such as those disclosed by U.S. Patent No. 4,808,510, U.S. Patent No. 4,355,087, and U.S. Patent No. 4,315,978, which are hereby incorporated by reference.

Thin photoresist layer 2 must be thick enough to mask thick photoresist layer 4 from subsequent exposure, once opacified. Suitable thicknesses of thin photoresist layer 2 are in the range of 0.2 to 2.0 mm, preferably 1.0 mm.

FIG. 2 is a cross-sectional view of the article of FIG. 1 after development. Laminate 1 is exposed through mask M to radiation R of a wavelength to which thin photoresist layer 2 is sensitive. Preferably, exposure in FIG. 1 is carried out by conventional projection printing -- that is exposure through a mask that does not contact laminate 1. Thin layer 2 may be exposed with a variety of sources including electron beam, ion beam, x-rays, deep ultraviolet, ultraviolet, or visible radiation. Radiation of a wavelength between 300 to 500 nm is preferred and between 365-436 nm is most preferred.

As shown in FIG. 2, laminate 1 has been developed after exposure by immersion in developer solution to remove the unexposed portions of thin photoresist layer 2 to form the negative of the predetermined pattern of mask M. Preferred developers include water-based or alcohol-based developers. The laminate of FIG. 2 consists of substrate 6, thick photoresist layer 4 and patterned, thin photoresist layer 2.

Next, the remnants of thin photoresist layer 2 in FIG. 2 are treated with an opacifying agent to convert this remainder of layer 2 to conformal optical mask 3, as shown in FIG. 3. Opacification may be carried out by a process such as solution imbibition, vapor imbibition, or selective deposition. The opacifying agent must absorb the radiation which will be subsequently used to expose the laminate. Suitable opacifying agents include dyes, pigments, and compounds containing elements whose atomic number is greater than 25, such as lead. Preferred are UV, near-UV, and visible light absorbing dyes such as those disclosed in U.S. Patent No. 4,876,167.

FIG. 3 is a cross-sectional view of the developed article of FIG. 2 after opacification. FIG. 3 shows a laminate consisting of substrate 6, thick photoresist layer 4 and conformal optical mask 3. The laminate of FIG. 3 is exposed to activating radiation which both activates thick, positive working photoresist layer 4 and is absorbed by conformal optical mask 3. Thick layer 4 may be exposed with electron beam, ion beam, x-rays, deepultraviolet, ultraviolet, or visible radiation. The radiation may be the same wavelength as that used to expose thin photoresist layer 2 in FIG. 1 or may be different. Preferred is radiation with a wavelength of 300 to 500 nm. Wavelengths of 365-436 nm are most preferred.

Next, the laminate of FIG. 3 is developed to remove the exposed, unmasked photoresist in thick photoresist layer 4. Such removal can be achieved by dissolving the photoresist in an appropriate developer. Suitable developers include the known alkaline, positive photoresist developers containing tetramethylammonium hydroxide. Such developing produces the laminate of FIG. 4, which is a cross-sectional view of the article of FIG. 3 after a second exposure and development. This article consists of substrate 6, patterned thick photoresist layer 4, and conformal mask 3.

FIGS. 5 and 6 illustrate the use of the laminate of FIG. 4 for wafer bumping in the production of integrated circuits. FIG. 5 is a cross-sectional view of the article of FIG. 4 after deposition of conductive material upon the substrate. The laminate of FIG. 4 is used as a template for the deposition of bumps 10 on substrate 6. As shown in FIG. 5, bumps 10 are deposited in the patterned openings created in thick photoresist layer 4 by a process such as electroplating. Bumps 10 may be any highly conductive material, such as gold, silver, nickel or copper.

Finally, remaining thick photoresist layer 4 also is removed by dissolution in a solvent, such as acetone or 1-methyl-2-pyrrolidinone. Thick photoresist layer 4 may also be removed by dry etching processes. Conformal mask 3 is either dissolved by the solvent used to remove photoresist layer 4 or is simply lifted off by solvent action or removed by dry etching. FIG. 6 is a cross-sectional view of the article of FIG. 5 after the remaining photoresist has been removed.

The process of the present invention produces an excellent reproduction of the original mask pattern that exhibits a high degree of pattern fidelity. It is very suitable as a template for the deposition of bonding pads as illustrated in FIGS. 5-6. The precise pattern reproduction allows a maximum number of bumps to be placed on the chip, which results in a high lead count. Therefore, this process is very useful in VLSI technology.

The following example is illustrative.

EXAMPLE

Silicon wafers four inches in diameter were used as the substrate for the photopatterning experiments. First, a 30 mm thick film of high viscosity, novolak-based, positive working AZ4620 photoresist (which is supplied by American Hoechst Corp.) was spun on wafers coated with a titanium-tungsten alloy and gold. The thick photoresist was spun on using a double coat process and baked twice for 40 seconds at 125°C. Then, a solution of 15 g poly(vinylbenzyl chloride) quaternized with N,N-dimethylethylamine cinnamate and 3-dimethylamino-1-propanol and 0.625 g of a 1:1 weight ratio mixture of pyridinium 3-[(7-methoxy-2-oxo-2H-1-benzopyran-3-yl) carbonyl]-1-methyl salt and 4-methylbenzenesulfonic acid sensitizer and 0.25 g of nonylphenoxypolyglycerol 10G surfactant (supplied by Olin Corp.) dissolved in 88 g of water was applied to nonrotating wafers which were then spun for 5 seconds at 500 revolutions per minute (rpm) and for 55 seconds at 2000 rpm. The coated wafers were air dried in a clean hood for 17 hours at room temperature. The thickness of the thin photoresist layer at this point was 1 mm.

The process involves imagewise light exposure, development, and dye imbibition of the thin photoresist layer. This is followed by flood exposure and development of the thick photoresist layer.

The negative-working thin photoresist layer was exposed, using a high-pressure mercury vapor light source by contacting the wafer face-to-face with the half-tone screen negative. The optimum exposure found necessary to produce a useful dot pattern was 5 seconds at 17 milliwatts per square centimeter power density.

Washout processing using spray development was carried out over a period of 40 seconds using pH-4 phthalate buffer solution.

The dye imbibition process was carried out for 4 minutes using the solution of 0.75 g of 3-cyano-1-phenyl-4-[3-(carboxymethylaminosulfonyl)-phenylazo]-2-pyrazolin-5-one UV-blue absorbing yellow dye and 0.3 g nonylphenoxypolyglycerol 10G surfactant (supplied by Olin Corp.) dissolved in 100 ml of pH-10 borate buffer system. The wafer was spray-rinsed for 5 seconds using fresh pH-10 borate buffer solution and air dried for 30 minutes at room temperature.

The thick, positive-working resist layer was flood exposed using the dyed, patterned, thin photoresist layer as the conformal optical mask. Exposure was carried out using a high-pressure mercury vapor light source spectrum filtered through Wratten 2B and 34A filters. In the plane of the wafer, the intensity was 2.5 milliwatts per square centimeter. The optimum exposure time found necessary to produce a useful pattern ranged between 15 and 30 minutes.

The exposed thick photoresist layer was spray-developed while spinning at 350 rpm for 5 minutes using tetraethylammonium hydroxide-based AZ400K developer (supplied by American Hoechst Corp.), diluted with water in the ratio of 1 part developer to 3 parts distilled water, spray-rinsed for 3 minutes using distilled water, and air dried at room temperature.

The two-dimensional pattern defined in the thick photoresist layer produced an excellent reproduction of the original half-tone screen mask pattern.

**Claims**

1. A process of forming a pattern useful for production of integrated circuits from a substrate having one surface coated with a thick photoresist layer over which a thin photoresist layer is applied, wherein the method comprises the steps of:

exposing said thin layer of photoresist to a predetermined pattern of activating radiation;

developing said exposed, thin layer of photoresist to produce the predetermined pattern or its negative in said thin layer of photoresist;

treating said patterned thin layer of photoresist with an opacifying agent suitable for absorbing particular wavelengths of activating radiation;

exposing said thick layer of photoresist, through the opacified, patterned, thin layer of photoresist, to the particular wavelengths of activating radiation; and

developing said thick layer of photoresist to produce the predetermined pattern or its negative in said thick layer of photoresist.

2. The process of claim 1, wherein said thin layer of photoresist is negative working and said thick layer of photoresist is positive working.

3. The process of claim 1, wherein said thin layer of photoresist and said thick layer of photoresist are each exposed to activating radiation of the same wavelength.

4. A process of forming a pattern useful for production of integrated circuits from a substrate having one surface coated with a thick layer of positive working photoresist 5-50 mm thick over which a thin layer of negative working photoresist is applied 0.2 to 2 mm thick, wherein the process comprises the steps of:

exposing said thin layer of photoresist to a predetermined pattern of activating radiation of a wavelength of 350-450 nm;

developing said exposed, thin layer of photoresist to produce the predetermined pattern or its negative in said thin layer of photoresist;

treating said patterned thin layer of photoresist with an opacifying agent suitable for absorbing radiation having a wavelength of 350 to 450 nm;

exposing said thick layer of photoresist, through the opacified, patterned, thin layer of photoresist to activating radiation having a wavelength of 350-450 nm; and

developing said thick layer of photoresist to produce the predetermined pattern or its negative in said thick layer of photoresist.

5. A process for use in production of integrated circuits comprising the steps of:

providing a substrate having one surface on which metal contact pads have been formed, said surface coated with a thick photoresist layer over which a thin photoresist layer is applied;

exposing said thin layer of photoresist to a predetermined pattern of activating radiation registratively aligned with said contact pads;

developing said exposed thin layer of photoresist to produce the predetermined pattern or its negative in said thin layer of photoresist;

treating said patterned thin layer of photoresist with an opacifying agent suitable for absorbing particular wavelengths of radiation;

exposing said thick layer of photoresist, through the opacified, patterned, thin layer of photoresist, to the particular wavelengths of radiation;

developing said thick layer of photoresist to dissolve portions of said thick layer of photoresist and form depressions therein that expose said metal contact pads;

depositing conductive material in said depressions in said thick layer of photoresist; and

removing substantially all photoresist from the substrate.

6. The process of claim 5, wherein said thin layer of photoresist and said thick layer of photoresist are both positive working.

7. The process of claim 5, further comprising:

bonding said substrate and said conductive material to an integrated circuit packaging system.

8. The process of claim 7, wherein said bonding of said substrate and said conductive material to said packaging system is achieved by tape automated bonding.

FIG.1

FIG.2

FIG.3

FIG.4

FIG.5

FIG.6

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 394 738 (SIEMENS AKTIENGESELLSCHAFT) | 1,3 | G03F7/095 |
| Y | * page 6, line 10 - page 6, line 48; claims; figures 1-4 * | 5,6 | G03F7/20 |
| Y | FR-A-2 310 633 (INTERNATIONAL BUSINESS MACHINES CORPORATION) | 5,6 | |
| | * claims; figures * | | |
| D | & US-A-4 004 044 (INTERNATIONAL BUSINESS MACHINES CORPORATION) | | |
| X | EP-A-0 098 922 (INTERNATIONAL BUSINESS MACHINES CORPORATION) | 1-4 | |
| Y | * claims; figures * | 5,6 | |
| A | WO-A-8 402 986 (WESTERN ELECTRIC COMPANY INC.) | 1-8 | |
| A | US-A-4 770 739 (ORVEK ET AL.) | 1-8 | |
| | * claims * | | |

TECHNICAL FIELDS SEARCHED (Int. Cl.5)

G03F

The present search report has been drawn up for all claims

| Place of search | Date of completion of the search | Examiner |
|---|---|---|
| THE HAGUE | 01 JULY 1992 | O. Hillebrecht |